# EUROPEAN PATENT SPECIFICATION

(11) **EP 3 070 753 B1**
(45) Date of publication and mention of the grant of the patent: **24.01.2018**
(21) Application number: 16159130.0
(22) Date of filing: 08.03.2016
(51) Int. Cl.: H01L 41/187

(54) **PIEZOELECTRIC ELEMENT, PIEZOELECTRIC ELEMENT APPLYING DEVICE, AND MANUFACTURING METHOD OF PIEZOELECTRIC ELEMENT**
PIEZOELEKTRISCHES ELEMENT, AUFBRINGUNGSVORRICHTUNG FÜR PIEZOELEKTRISCHES ELEMENT UND HERSTELLUNGSVERFAHREN EINES PIEZOELEKTRISCHEN ELEMENTS
ÉLÉMENT PIÉZOÉLECTRIQUE, DISPOSITIF D'APPLICATION ET PROCÉDÉ DE FABRICATION D'UN ÉLÉMENT PIÉZOÉLECTRIQUE

(30) Priority: 20.03.2015 JP 2015058690
(43) Date of publication of application: 21.09.2016
(73) Proprietor: Seiko Epson Corporation, Shinjuku-ku Tokyo (JP)
(72) Inventor: SUMI, Koji, Suwa-shi, Nagano 392-8502 (JP); KOBAYASHI, Tomokazu, Suwa-shi, Nagano 392-8502 (JP); KITADA, Kazuya, Suwa-shi, Nagano 392-8502 (JP)
(74) Representative: Miller Sturt Kenyon

(56) References cited:
- JP-A- 2007 287 918
- US-B2- 7 482 736

## Description

### BACKGROUND

### 1. Technical Field

The present invention relates to a piezoelectric element, a piezoelectric element applying device, and a manufacturing method of the piezoelectric element.

### 2. Related Art

In general, a piezoelectric element includes a piezoelectric layer including electromechanical conversion properties and two electrodes holding the piezoelectric layer. Recently, a development of a device (piezoelectric element applying device) which uses such a piezoelectric element as a driving source has actively progressed. As the piezoelectric element applying device, there are liquid ejecting heads represented by ink jet type recording heads, MEMS elements represented by piezoelectric MEMS elements, ultrasonic measuring devices represented by ultrasonic sensors, and the like, and piezoelectric actuator devices, and the like are further included.

As one of materials (piezoelectric materials) of the piezoelectric layer of the piezoelectric element, sodium potassium niobate (KNN; (K, Na)NbO₃) is proposed (for example, refer to JP-A-2008-305916 and JP-A-2009-200468). In JP-A-2008-305916, it is disclosed that a piezoelectric body is a piezoelectric film in which crystals are constituted by (NaₓK_{y}Li_{z})NbO₃ as a main phase, and the piezoelectric film is a polycrystal thin film which is preferentially oriented to, one of a <001> axis and a <110> axis, or a crystal axis of both sides in a normal direction of a surface of a substrate, and the crystals oriented to each of crystal axes are formed in a direction having the same crystal axis even in an inner surface direction of the substrate. In addition, in JP-A-2009-200468, a piezoelectric thin film element is disclosed in which an orientation ratio to a (001) plane orientation of a piezoelectric thin film is 80% or more, and an angle of 2θ of a diffraction peak by the (001) plane of the piezoelectric thin film in an X-ray diffraction pattern (2θ/θ) is in a range of 22.1° ≤ 2θ ≤ 22.5°.

However, the piezoelectric thin film in JP-A-2008-305916 is a single crystal, and crystal orientation is in a specific direction in an inner surface direction. Such a crystal is likely to generate a cleavage breaking, therefore, it is not appropriate for a use of an actuator which uses a mechanical deformation.

In addition, in JP-A-2009-200468, a diffraction peak of a (001) plane of the KNN is defined as a state in which a remaining stress is 0 or barely exists, and an angle of 2θ is preferably in a range of 22.1° ≤ 2θ ≤ 22.5°. However, since a crystal base of the KNN near the morphotropic phase boundary (MPB) is a monoclinic system and a polarization axis of the monoclinic system is distributed in a c axis or a direction deviated from the c axis, a displacement corresponding to a movement, in which the polarization is rotated at the time of being influenced by an electric field, is generated. It is a nonlinear movement and a displacement which cannot be reused by pinning of the polarization. Accordingly, for example, when it is used as an actuator, a problem in that durability of the displacement greatly deteriorates is generated. In addition, when it is used as a sensor, dependence properties of the displacement on a driving voltage include a nonlinear part, therefore, a problem in that driving controlling is not easy is generated.

US 7,482,736 discloses a piezoelectric laminate including a base and a first piezoelectric layer formed above the base and including potassium sodium niobate. The first piezoelectric layer is shown by a compositional formula (KₐNa₁₋ₐ)ₓNbO₃, "a" and "x" in the compositional formula being respectively 0.1<a<1 and 1≤x≤1.2.

JP 2007-287918 discloses a piezoelectric laminate that comprises a substrate, a template layer formed above the substrate, and a piezoelectric layer consisting of potassium sodium niobate and formed above the template layer.

### SUMMARY

An advantage of some aspects of the invention is to provide a piezoelectric element which has excellent linear properties of a displacement amount with respect to an applied voltage and a piezoelectric element applying device, and a manufacturing method of the piezoelectric element.

According to an aspect of the invention, there is provided a piezoelectric element as defined in claim 1.

Moreover, in this specification, a radiation source used at the time of observing the X-ray diffraction peak is CuKα (wavelength λ = 1.54A).

According to the aspect, the diffraction peak 2θ of the (001) plane of the KNN is higher than a case in which a remaining stress is 0, and is 22.51° or more and 22.95° or less, and therefore, the piezoelectric element has excellent linear properties of the displacement with respect to the applied voltage.

In the piezoelectric element, in Formula (1), x is 0 or more and 0.91 or less. Accordingly, the linear properties of the displacement with respect to the applied voltage becomes further excellent.

According to another aspect of the invention, there is provided a piezoelectric element applying device including the piezoelectric element above.

According to the aspect, the diffraction peak 2θ of the (100) plane of KNN is higher than a case in which the remaining stress is 0, and is in a range of 22.51° or more and 22.95° or less, and thus the piezoelectric element applying device, which includes the piezoelectric element having excellent linear properties of the displacement with respect to the applied voltage, can be provided.

According to still another aspect of the invention, there is a provided a manufacturing method as defined in claim 3.

According to the aspect, the diffraction peak 2θ of the (100) plane of the KNN is higher than a case in which the remaining stress is 0, and is in a range of 22.51° or more and 22.95° or less, and thus the piezoelectric element having excellent linear properties of the displacement with respect to the applied voltage, can be manufactured.

In the method of the aspect, it is preferable that tensile stress by which a crystal lattice is contracted in a film thickness direction is applied to the piezoelectric layer. Accordingly, the tensile stress is applied to the piezoelectric layer, and thus the diffraction peak 2θ of the (100) plane is further reliably in a predetermined range.

In the method of the aspect, it is preferable that the piezoelectric layer is produced by a wet method. Accordingly, the piezoelectric layer having the internal stress can be relatively easily manufactured, and the diffraction peak 2θ of the (100) plane can be further reliably in a predetermined range.

### BRIEF DESCRIPTION OF THE DRAWINGS

Embodiments of the invention will now be described by way of example only with reference to the accompanying drawings, wherein like numbers reference like elements.
Fig. 1 is a view illustrating a schematic configuration of a recording apparatus.
Fig. 2 is an exploded perspective view illustrating a schematic configuration of a recording head.
Figs. 3A and 3B are respectively a plan view and a sectional view of the schematic configuration of the recording head.
Figs. 4A to 4D are views describing a manufacturing example of the recording head.
Figs. 5A to 5C are views describing a manufacturing example of the recording head.
Fig. 6 is a graph illustrating X-ray diffraction patterns of Example 1, Example 3, and Example 4.
Fig. 7 is a graph illustrating the X-ray diffraction pattern of Example 2.
Fig. 8 is a graph illustrating a relationship of positions (2θ) of the X-ray diffraction patterns and x of Example 1 to Example 4.
Fig. 9 is a graph illustrating an X-ray diffraction pattern of Comparative example.
Fig. 10 is graph illustrating a relationship of an applied voltage and a displacement amount of Example 6 and Example 7.

### DESCRIPTION OF EXEMPLARY EMBODIMENTS

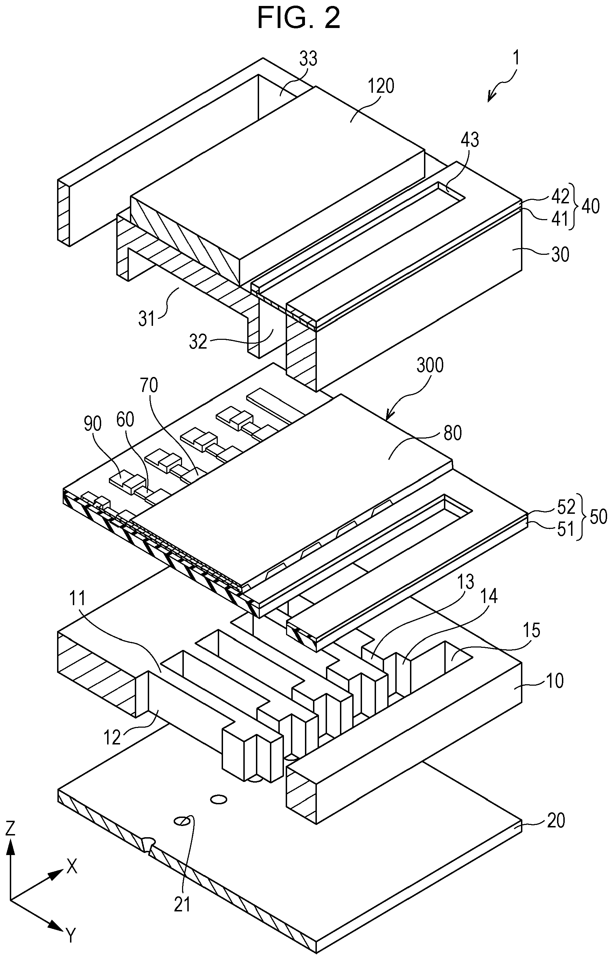

Hereinafter, embodiments of the invention will be described with reference to drawings. A description as follows is a description of an aspect of the invention, and can be modified arbitrarily within a range of the invention. Same numerals given in each drawing mean the same members, and appropriately, descriptions thereof will be omitted. In addition, in Fig. 2 to Fig. 5C, X, Y, and Z illustrate three spatial axes which intersect with each other. In this specification, directions along these axes will be respectively described as an X direction, a Y direction, and a Z direction. The Z direction indicates a thickness direction or a stacking direction of plates, layers, and films. The X direction and the Y direction are inner surface directions of plates, layers, and films.

### Embodiment 1

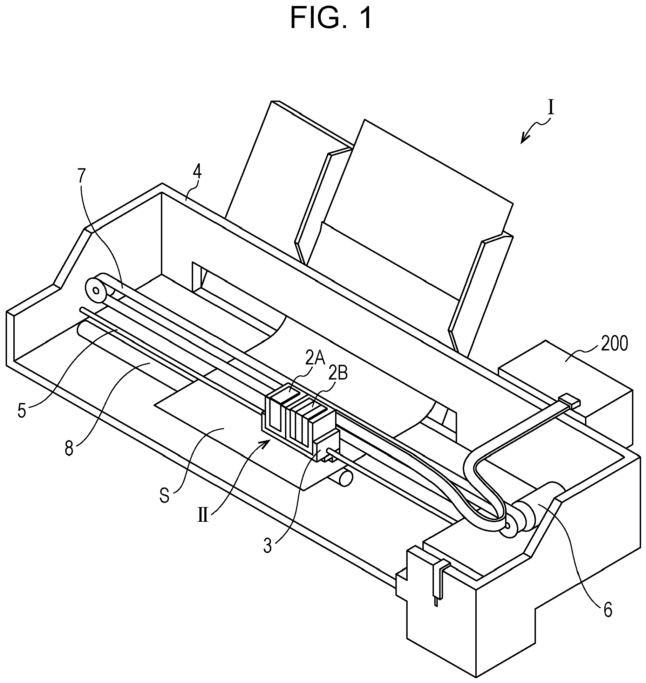

Fig. 1 illustrates a schematic configuration of an ink jet type recording apparatus (recording apparatus) which is an example of a liquid ejecting apparatus.

In the ink jet type recording apparatus I, an ink jet type recording head unit (head unit II) is provided to be detachable from cartridges 2A and 2B. The cartridges 2A and 2B constitute an ink supplying unit. The head unit II includes a plurality of ink jet type recording heads (recording heads), and is mounted on a carriage 3. The carriage 3 is provided to be freely movable in a shaft direction on a carriage shaft 5 provided to an apparatus main body 4. Such a head unit II or the carriage 3 is capable of discharging, for example, a black ink composition and color ink composition.

A driving force of a driving motor 6 is applied to the carriage 3 through a plurality of gears (not illustrated) and a timing belt 7. Accordingly, the carriage 3 is moved along the carriage shaft 5. Meanwhile, in the apparatus main body 4, a transportation roller 8 is provided as a transportation unit. A recording sheet S, which is a recording medium, such as paper, is transported by the transportation roller 8. Moreover, the transportation unit is not limited to the transportation roller, and may be a belt, a drum, or the like.

In the ink jet type recording head described above, a piezoelectric element is used as a piezoelectric actuator device. Various characteristics (durability, ink ejecting properties, or the like) of the ink jet type recording apparatus I can be prevented from being deteriorated using the piezoelectric element to be described later in detail.

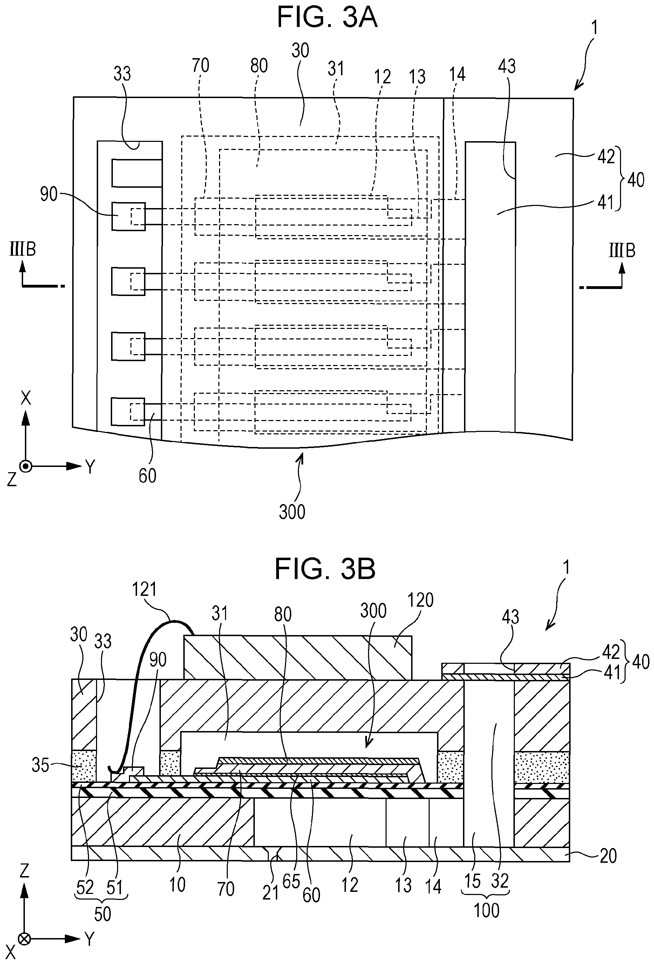

Next, the ink jet type recording head will be described. Fig. 2 is an exploded perspective view illustrating a schematic configuration of the ink jet type recording head. Fig. 3A is a plan view illustrating a schematic configuration of the ink jet type recording head (a plan view of a flow path forming substrate when seen from the piezoelectric element side), and Fig. 3B is a cross-sectional view taken along a line IIIB-IIIB of Fig. 3A.

In a flow path forming substrate 10, a plurality of partition walls 11 are formed. A plurality of pressure generating chambers 12 are divided by the partition walls 11. That is, in the flow path forming substrate 10, the pressure generating chambers 12 are arranged in the X direction (a direction where nozzle openings 21 discharging the same color ink are arranged). As such a flow path forming substrate 10, for example, a silicon single crystal substrate can be used.

In the flow path forming substrate 10, ink supplying paths 13 and communication paths 14 are formed in one end side in the Y direction of the pressure generating chamber 12. The ink supplying path 13 is at one side of the pressure generating chamber 12 and projects in the X direction, and an opening volume thereof becomes reduced. In addition, the communication path 14 has a width substantially the same as that of the pressure generating chamber 12 in the X direction. Outside of the communication path 14 (+ Y direction), a communication portion 15 is formed. The communication portion 15 constitutes a part of a manifold 100. The manifold 100 is a common ink chamber of each of the pressure generating chambers 12. Accordingly, in the flow path forming substrate 10, a liquid flow path, which is configured to have the pressure generating chamber 12, the ink supplying path 13, the communication path 14, and the communication portion 15, is formed.

On a surface (a surface of the - Z direction side) of one side of the flow path forming substrate 10, for example, a nozzle plate 20 made of SUS is bonded thereto. In the nozzle plate 20, the nozzle openings 21 are arranged in the X direction. The nozzle opening 21 communicates with each of the pressure generating chambers 12. The nozzle plate 20 can be bonded to the flow path forming substrate 10 by an adhesive, a heat-welding film, or the like.

On a surface (a surface of the + Z direction side) of the other side of the flow path forming substrate 10, a vibration plate 50 is formed. The vibration plate 50 is formed of, for example, an elastic film 51 formed on the flow path forming substrate 10, and a zirconium oxide layer 52 formed on the elastic film 51. The elastic film 51 is made of, for example, silicon dioxide (SiO₂), and the zirconium oxide layer 52 is made of zirconium oxide (ZrO₂). The elastic film 51 need not be a member different from the flow path forming substrate 10. A part of the flow path forming substrate 10 is processed to be thin, and the processed part may be used as the elastic film. A thickness of the zirconium oxide layer 52 is approximately 20 nm. The zirconium oxide layer 52 functions as a stopper which prevents potassium and sodium, which constitute elements of a piezoelectric layer 70, from permeating through a first electrode 60 and reaching the flow path forming substrate 10, at the time of forming a piezoelectric layer 70 to be described later.

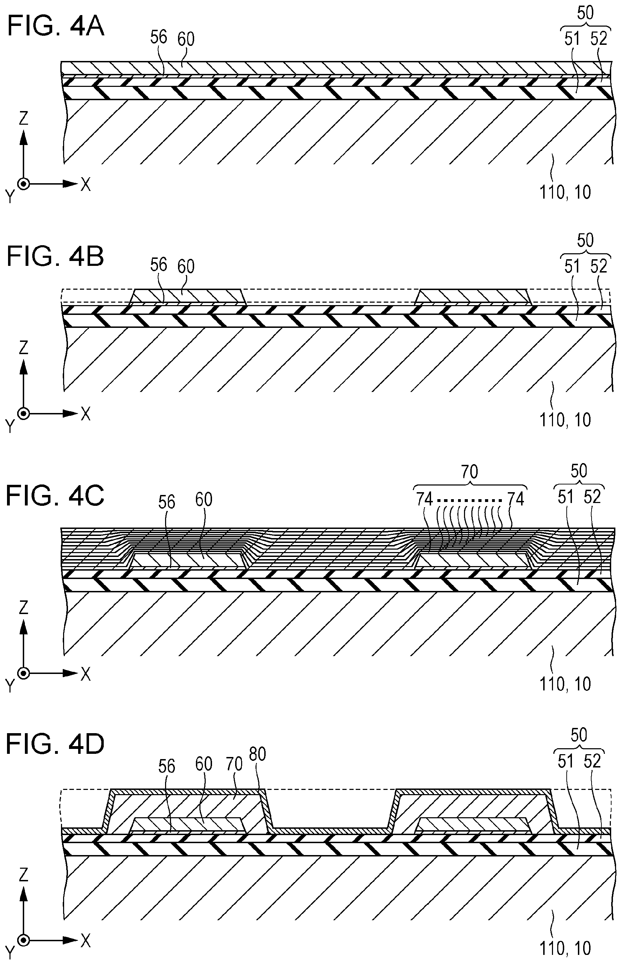

On the zirconium oxide layer 52, a piezoelectric element 300 including the first electrode 60, the piezoelectric layer 70, and a second electrode 80 is formed through an adhesion layer 56 (see Fig. 4A) having a thickness of approximately 10 nm. The adhesion layer 56 is made of, for example, a titanium oxide (TiO_{X}) layer, a titanium (Ti) layer, a silicon nitride (SiN) layer, or the like, and includes a function for improving adhesive properties of the piezoelectric layer 70 and the vibration plate 50. In addition, when the titanium oxide (TiO_{X}) layer, the titanium (Ti) layer, or the silicon nitride (SiN) layer are used as an adhesion layer, like the zirconium oxide layer 52 described above, the adhesion layer 56 functions as a stopper which prevents potassium, which constitutes an element of the piezoelectric layer, from permeating through a first electrode 60 and reaching the flow path forming substrate 10 at the time of forming a piezoelectric layer 70 to be described later. The adhesion layer 56 can be omitted.

In the embodiment, the vibration plate 50 and the first electrode 60 are displaced due to a displacement of the piezoelectric layer 70 having electromechanical conversion properties. That is, in the embodiment, the vibration plate 50 and the first electrode 60 substantially function as the vibration plate. The elastic film 51 and the zirconium oxide layer 52 can be omitted, and only the first electrode 60 may function as the vibration plate. When the first electrode 60 is directly provided on the flow path forming substrate 10, the first electrode 60 may be protected by a protection film having insulating properties, or the like so that the first electrode 60 does not come into contact with ink.

The first electrode 60 is divided with respect to in every pressure generating chamber 12, that is, the first electrode 60 is constituted by an individual electrode which is independent for each pressure generating chamber 12. The first electrode 60 is formed to have a width narrower than that of the pressure generating chamber 12 in the X direction. In addition, the first electrode 60 is formed to have a width wider than that of the pressure generating chamber 12 in the Y direction. That is, in the Y direction, both end portions of the first electrode 60 is formed on the outside of a region facing the pressure generating chamber 12. In an end portion of one side of the first electrode 60 (an end portion of the - Y direction side), a lead electrode 90 is connected.

The piezoelectric layer 70 is provided between the first electrode 60 and the second electrode 80. The piezoelectric layer 70 is formed to have a width wider than that of the first electrode in the X direction. In addition, the piezoelectric layer 70 is formed to have a wide width greater than a length of the Y direction of the pressure generating chamber 12 in the Y direction. In the Y direction, an end portion (an end portion of the + Y direction side) of the ink supplying path 13 side of the piezoelectric layer 70 is formed on the outside of an end portion of the first electrode 60. That is, an end portion (an end portion of the + Y direction side) of the other side of the first electrode 60 is covered with the piezoelectric layer 70. Meanwhile, an end portion (an end portion of the - Y direction side) of one side of the piezoelectric layer 70 is positioned at an inner side further than an end portion (the end portion of the - Y direction side) of one side of the first electrode 60. That is, the end portion (the end portion of the - Y direction side) of one side of the first electrode 60 is not covered with the piezoelectric layer 70.

The second electrode 80 is successively formed on the piezoelectric layer 70, the first electrode 60, and the vibration plate 50 in the X direction. That is, the second electrode 80 is constituted as a common electrode applying to a plurality of piezoelectric layers 70. The first electrode 60 rather than the second electrode 80 may be formed and used as a common electrode instead.

A protection substrate 30 is bonded onto the flow path forming substrate 10 in which the piezoelectric element 300 described above is formed, by an adhesive 35. The protection substrate 30 includes a manifold portion 32. At least a part of the manifold 100 is constituted by the manifold portion 32. The manifold portion 32 according to the embodiment penetrates the protection substrate 30 in a thickness direction (Z direction), and is formed further through a width direction (X direction) of the pressure generating chamber 12. Also, as described above, the manifold portion 32 communicates with the communication portion 15 of the flow path forming substrate 10. With such a configuration, the manifold 100 which becomes a common ink chamber of each of the pressure generating chambers 12 is formed.

In the protection substrate 30, a piezoelectric element protecting portion 31 is formed on a region including the piezoelectric element 300. The piezoelectric element protecting portion 31 includes a space which does not impede a movement of the piezoelectric element 300. The space may be sealed or may be not sealed. In the protection substrate 30, a through hole 33, which penetrates the protection substrate 30 in the thickness direction (Z direction), is provided. In the inside of the through hole 33, an end portion of the lead electrode 90 is exposed.

A driving circuit 120 which functions as a signal processing portion is fixed onto the protection substrate 30. As the driving circuit 120, for example, a circuit substrate or a semiconductor integrated circuit (IC) can be used. The driving circuit 120 and the lead electrode 90 are electrically connected to each other through connection wiring 121. The driving circuit 120 can be electrically connected to a printer controller 200. Such a driving circuit 120 functions as a control unit according to the embodiment.

On the protection substrate 30, a compliance substrate 40 which is configured to have a sealing film 41 and a fixing plate 42 is bonded. A region facing the manifold 100 of the fixing plate 42 is an opening portion 43 which is a completely removed in the thickness direction (Z direction). A surface of one side of the manifold 100 (a surface of the - Z direction side) is only sealed with the sealing film 41 having flexibility.

Next, the piezoelectric element 300 will be described in detail. The piezoelectric element 300 includes the first electrode 60, the second electrode 80, and the piezoelectric layer 70 provided between the first electrode 60 and the second electrode 80. A thickness of the first electrode 60 is approximately 200 nm. The piezoelectric layer 70 is a so-called piezoelectric thin film having a thickness of 50 nm or more and 2000 nm or less. A thickness of the second electrode 80 is approximately 50 nm. All of thicknesses of each of elements exemplified here is an example, and can be changed within a range within the scope of the invention as defined by the claims.

As materials of the first electrode 60 and the second electrode 80, a noble metal such as platinum (Pt) or iridium (Ir) is preferable. A material of the first electrode 60 or a material of the second electrode 80 may be a material having conductivity. The material of the first electrode 60 and the material of the second electrode 80 may be the same as each other, or may be different from each other.

The piezoelectric layer 70 is a complex oxide of the perovskite structure expressed by a general formula ABO₃, and includes a piezoelectric material which is made of a KNN based complex oxide expressed by Formula (2) described below.

(K_{X}, Na_{1-X})NbO₃ ··· (2)

The piezoelectric layer 70 is constituted by a polycrystal which is preferentially oriented to the (100) plane, and has a thickness of 50 nm or more and 2000 nm or less, and the diffraction peak position (2θ) of the X-ray derived from the (100) plane of the piezoelectric layer 70 is 22.51° or more and 22.95°or less.

The complex oxide expressed by Formula (2) described above is a so called KNN based complex oxide. Since the KNN based complex oxide is a non-lead based piezoelectric material in which content of lead (Pb), and the like is suppressed, biocompatible properties are excellent and an environmental load is also reduced. Also, the KNN based complex oxide has excellent piezoelectric properties even among the non-lead based piezoelectric materials, and thus it has an advantage for improving various properties. Therefore, the KNN based complex oxide has the Curie temperature relatively higher than the other non-lead based piezoelectric materials (for example, BNT-BKT-BT; [(Bi, Na)TiO₃]-[(Bi, K)TiO₃]-[BaTiO₃]), and depolarization due to an increase of the temperature is less likely to be generated, and thus it can be used at a high temperature.

In Formula (2) described above, a content of K is equal to or more than 54 mole % with respect to a total amount of metallic elements which constitutes an A site, or a content of Na is preferably equal to or less than 46 mole % with respect to a total amount of metallic elements which constitutes an A site. Accordingly, the complex oxide includes a composition which has an advantage for piezoelectric properties.

The piezoelectric material constituting the piezoelectric layer 70 may be the KNN based complex oxide, and is not limited to the composition described in Formula (2) described above. For example, the other metallic elements (additive substance) may be included in the A site or a B site of a potassium sodium niobate. As an example of such additive substances, manganese (Mn), lithium (Li), barium (Ba), calcium (Ca), strontium (Sr), zirconium (Zr), titanium (Ti), bismuth (Bi), tantalum (Ta), antimony (Sb), iron (Fe), cobalt (Co), silver (Ag), magnesium (Mg), zinc (Zn), copper (Cu), and the like are exemplified.

The additive substances of these kinds may be included as one or more. Generally, the amount of the additive substance is 2at0% or less, preferably 15at% or less, and more preferably 10at% or less with respect to the total amount of elements which are main components. Various properties are improved so as to diversify configurations or functions using the additive substance. Even in a case of the complex oxide containing the other elements, it is preferable that an ABO₃ type perovskite structure is included.

An alkali metal of A site may be excessively added. The complex oxide of Formula (2) can be also expressed in Formula (3) to be described below. In Formula (3) described below, a indicates mole quantity of K and Na. When a is greater than 1, the alkali metal of A site is excessively added to a composition. For example, if a is equal to 1.1 and Nb is 100%, it means that 110% amount of K and Na is contained. Moreover, in Formula (3), a is equal to or more than 1, and more preferably, is equal to or less than 1.2.

(K_{aX}, Na_{a(1-X)})NbO₃ ··· (3)

"The ABO₃ type complex oxide of the perovskite structure expressed by Formula (1)" in this specification is not limited to only the ABO₃ type complex oxide of the perovskite structure expressed by Formula (1). That is, a material having "the ABO₃ type complex oxide of the perovskite structure expressed by Formula (1)" in this specification has a material expressed as a mixed crystal which contains the ABO₃ type complex oxide of the perovskite structure expressed by Formula (1) and the other complex oxide having the ABO₃ type perovskite structure. In addition, as long as a basic characteristic of the piezoelectric layer 70 is not changed, materials deviated from a stoichiometric composition due to loss or excess of elements or materials, in which a part of an element is replaced by the other elements, are also included.

The other complex oxide is not limited to a range of the invention; however, the non-lead based piezoelectric material, in which the content of lead (Pb) is suppressed, or the non-lead based piezoelectric material, in which the content of bismuth (Bi) is suppressed, is preferably used. Accordingly, it becomes the piezoelectric element 300 in which biocompatible properties are excellent and the environmental load is also reduced.

The piezoelectric layer 70 made of such a complex oxide is made of a polycrystal which is preferentially oriented to a (100) plane in the embodiment. The piezoelectric layer 70 is likely to be naturally oriented to the (100) plane, but may be oriented using a predetermined orientation controlling layer which is provided as needed. The piezoelectric layer 70 in which a crystal plane is preferentially oriented to the (100) plane, is likely to improve various characteristics compared to a piezoelectric layer which is arbitrarily oriented. In addition, the KNN based complex oxide is in a monoclinic system, and a polarization axis becomes a c axis or a direction deviated from the c axis, and thus a displacement is preferably maximized. Moreover, "being preferentially oriented to the (100) plane" also means a case in which whole crystals of the piezoelectric layer 70 are oriented to the (100) plane, and a case in which most crystals (crystals equal to or more than 50%, preferably equal to or more than 80%, and more preferably equal to or more than 90%) are oriented to the (100) plane.

In addition, the piezoelectric layer 70 is a polycrystal so that stress in the surface is dispersed and uniform, therefore, breakdown of the piezoelectric element 300 due to stress is less likely to be generated, and reliability thereof is improved.

Further, a detailed description thereof will be described later; however, in the embodiment, the diffraction peak position (2θ) of the X-ray derived from the (100) plane of the piezoelectric layer 70 is in a range of 22.51° to 22.95°. Accordingly, a displacement with respect to a voltage applied to the piezoelectric layer 70 has excellent linear properties, and a deterioration of durability properties of the displacement of the piezoelectric element 300 can be suppressed. Moreover, a radiation source used at the time of observing the X-ray diffraction peak is CuKα (wavelength λ = 1.54A).

The diffraction peak position (2θ) of the X-ray derived from the (100) plane can be controlled to be in a range of 22.51° or more and 22.95° or less, by adjusting of a composition of a material constituting the piezoelectric layer 70 or controlling the internal stress thereof. In addition, controlling the internal stress of the piezoelectric layer 70 can be performed by selecting a manufacturing method, or adjusting a condition (film thickness, adjusting forming temperature, or the like) in a manufacturing process.

Regarding the composition, in Formula (2) or Formula (3) described above, when x is set to 0.91 or less which is greater than 0, the piezoelectric layer 70 can be obtained in which the diffraction peak position (2θ) of the X-ray derived from the (100) plane is in a range of 22.51° or more and 22.95° or less.

In addition, as a manufacturing method of the piezoelectric layer 70, a chemical solution method, that is, a wet method is preferable. According to the wet method, the piezoelectric layer 70 having an internal stress can be manufactured relatively easily, and therefore, the piezoelectric layer 70 can be relatively easily obtained in which the diffraction peak position (2θ) of the X-ray derived from the (100) plane is in a range of 22.51° or more and to 22.95° or less.

Moreover, a manufacturing method relating to controlling of the internal stress by adjusting of a film thickness, and controlling of the internal stress by adjusting of a film forming temperature will be described in detail with reference to examples.

Here, the internal stress of the piezoelectric layer 70 is preferably tensile stress in a film thickness direction which is a direction a crystal lattice is contracted. Accordingly, the piezoelectric layer 70 can be relatively easily obtained in which the diffraction peak position (2θ) of the X-ray derived from the (100) plane is in a range of 22.51° or more and 22.95° or less. That is, in the piezoelectric layer 70 to which the tensile stress is applied, compared to the piezoelectric layer to which the tensile stress is not applied in the same composition, the diffraction peak position (2θ) of the X-ray derived from the (100) plane is shifted to a large value. In a wet method, the piezoelectric material is fired at a high temperature so as to be crystallized, and thus such tensile stress can be easily obtained. Meanwhile, when the piezoelectric layer is formed by a gas phase method such as a sputtering method, the piezoelectric material does not need to be crystallized by firing at a high temperature, therefore, the internal stress is rarely generated, and such tensile stress in the piezoelectric layer 70 formed by the wet method cannot be obtained. In addition, the diffraction peak position (2θ) of the X-ray derived from the (100) plane of the piezoelectric layer formed by the gas phase method becomes smaller than the value described above.

Next, an example of a manufacturing method of the piezoelectric element 300 will be described with a manufacturing method of the ink jet type recording head 1.

First, a silicon substrate 110 is set to a reference. Next, the elastic film 51 made of silicon dioxide is formed on a surface of the silicon substrate 110 by being thermally-oxidized. A zirconium film is further formed on the elastic film 51 by the sputtering method, and the zirconium oxide layer 52 is obtained by thermally-oxidizing the film. In this way, the vibration plate 50 constituted by the elastic film 51 and the zirconium oxide layer 52 is formed. Subsequently, the adhesion layer 56 made of titanium oxide is formed on the zirconium oxide layer 52. The adhesion layer 56 can be formed by the sputtering method, a method of thermally-oxidizing, or the like. Also, as illustrated in Fig. 4A, the first electrode 60 is formed on the adhesion layer 56. The first electrode 60 can be formed by, for example, a vapor phase growth method consisting of PVD(Physical Vapor Deposition) such as sputtering method, vacuum vapor deposition, laser ablation method and so on, CVD(Chemical vapor deposition) such as MOCVD(Metal Organic Chemical Vapor Deposition) and wet method containing sol gel method and MOD(Metal Organic Deposition) method.

Subsequently, when the adhesion layer 56 and the first electrode 60 are patterned at the same time, it becomes a shape illustrated in Fig. 4B. Patterning can be performed by, for example, dry etching such as reactive ion etching (RIE) or ion milling, or wet etching using an etching solution.

Next, as illustrated in Fig. 4C, the piezoelectric layer 70 is formed. The piezoelectric layer 70 is preferably formed by the wet method such as a metal organic deposition (MOD) method or a sol-gel method. As illustrated in Figs. 4C and 4D, the piezoelectric layer 70 formed by a wet method includes a plurality of piezoelectric films 74 which are formed by a series of processes from a process of coating with a precursor solution (coating process) to a process of firing a precursor film (firing process). That is, the piezoelectric layer 70 is formed by repeatedly performed the series of processes from the coating process to the firing process many times.

An example of a specific forming sequence when the piezoelectric layer 70 is formed by the wet method is as follows. First, an MOD solution including a predetermined metallic complex or a sol-form precursor solution is prepared. The precursor solution is made by dissolving or dispersing the metallic complex, which constitutes the complex oxide containing K, Na, and Nb by firing, in an organic solvent. At this time, the metallic complex containing the additive substance such as Mn may be further mixed thereinto.

As the metallic complex containing K, for example, potassium carbonate and potassium acetate are exemplified. As the metallic complex containing Na, for example, sodium carbonate and sodium acetate are exemplified. As the metallic complex containing Nb, for example, pentaethoxyniobium is exemplified. At this time, two or more of the metallic complexes may be used. For example, as the metallic complex containing K, potassium carbonate and potassium acetate may be used. As a solvent, 2-n butoxyethanol, n-octane, a mixed solvent of these, or the like is exemplified. The precursor solution may include an additive agent which makes dispersion of the metallic complex containing K, Na, and Nb stabilized. As such an additive agent, 2-ethyl hexane acid, or the like is exemplified.

Also, the precursor solution is coated on a substrate in which the vibration plate 50, the adhesion layer 56, and the first electrode 60 are formed, and thus a precursor film is formed (coating process). Subsequently, the precursor film is heated at a predetermined temperature, for example, 130°C to 250°C and is dried for a predetermined time (drying process). Next, the dried precursor film is heated to a predetermined temperature, for example, 300°C to 450°C, and is pyrolyzed by being maintained at the temperature for a predetermined time (pyrolyzing process). Finally, the pyrolyzed precursor film is heated at a higher temperature, for example, 650°C to 800°C, and is maintained at this temperature for a predetermined time so as to be crystallized, and thus the piezoelectric film 74 is completed (firing process).

As a heating device used for the drying process, the pyrolyzing process, and the firing process, for example, a rapid thermal annealing (RTA) device which radiates heat by applying light of an infrared lamp, a hot plate, or the like is exemplified. The piezoelectric layer 70 made of a plurality of layers of the piezoelectric films 74 is formed by repeatedly performing the processes described above. Moreover, in the series of processes from the coating process to the firing process, when the coating process to the degreasing process are performed many times, then the firing process may be performed.

In the embodiment, alkali metals (K and Na) are contained in the piezoelectric material. The alkali metals are likely to be diffused in the first electrode 60 or the adhesion layer 56 by the firing process. Conversely, when the alkali metals are excess the first electrode 60 and the adhesion layer 56 and reaches the silicon substrate 110, it causes a reaction with silicon. However, in the embodiment, the zirconium oxide layer 52 or the adhesion layer 56 functions as a stopper of an alkali metal. Accordingly, the alkali metal can be prevented from reaching the silicon substrate 110.

A film thickness of the piezoelectric film 74 of a first layer (closest to the first electrode 60) is preferably set to 10 nm or more and 50 nm or less. In addition, the film thicknesses of the piezoelectric films 74 of a second layer and the next layers are respectively set to 100 nm or more and 200 nm or less.

When the film thickness of the piezoelectric film 74 of the first layer is set to 50 nm or less, at the time of crystallizing, a lattice constant in a surface of the piezoelectric film 74 is widened by stress generated due to a difference in the linear expansion coefficients of the piezoelectric film 74 and the difference with a substrate 110. A difference between the lattice constant of the piezoelectric film 74 of the first layer and the lattice constant the piezoelectric film 74 of the second layer becomes great, and thus an effect in which the stress between the first layer and the second layer becomes relaxed is generated. However, since the stress is still concentrated between the silicon substrate 110 (strictly, first electrode 60) and the piezoelectric film 74 of the first layer, suitable internal stress in the entirety of the piezoelectric layer 70 can be maintained. Meanwhile, when the film thickness of the piezoelectric film 74 of the first layer is lower than 10 nm, the piezoelectric film 74 of the first layer is not resistant to stress or is not capable of functioning as an actual film because it is too thin, and therefore, suitable internal stress cannot be generated.

A thickness of the piezoelectric layer 70 (total of the thicknesses of the plurality of piezoelectric films 74) is preferably 50 nm or more and 2000 nm or less. This is because that when the thickness of the piezoelectric layer 70 is smaller than that value, sufficient properties cannot be obtained, on the other hand, when the thickness is greater than that value, the possibility of cracks being generated is increased. In addition, when the thickness of the piezoelectric layer 70 is set to 550 nm or more and 1250 nm or less, further sufficient properties can be obtained, and the possibility of generating cracks is further decreased.

After that, the piezoelectric layer 70 configured to have a plurality of the piezoelectric films 74 is patterned to be shaped as illustrated in Fig. 4D. Patterning can be performed by a dry etching such as so called a reactive ion etching or an ion milling, or a wet etching using an etching solution. After that, the second electrode 80 is formed on the piezoelectric layer 70. The second electrode 80 can be formed by a method which is the same manner of forming the first electrode 60. According to the above described processes, the piezoelectric element 300 which includes the first electrode 60, the piezoelectric layer 70, and the second electrode 80 is complete. In other words, components at a position at which the first electrode 60, the piezoelectric layer 70, and the second electrode 80 overlap each other become the piezoelectric element 300.

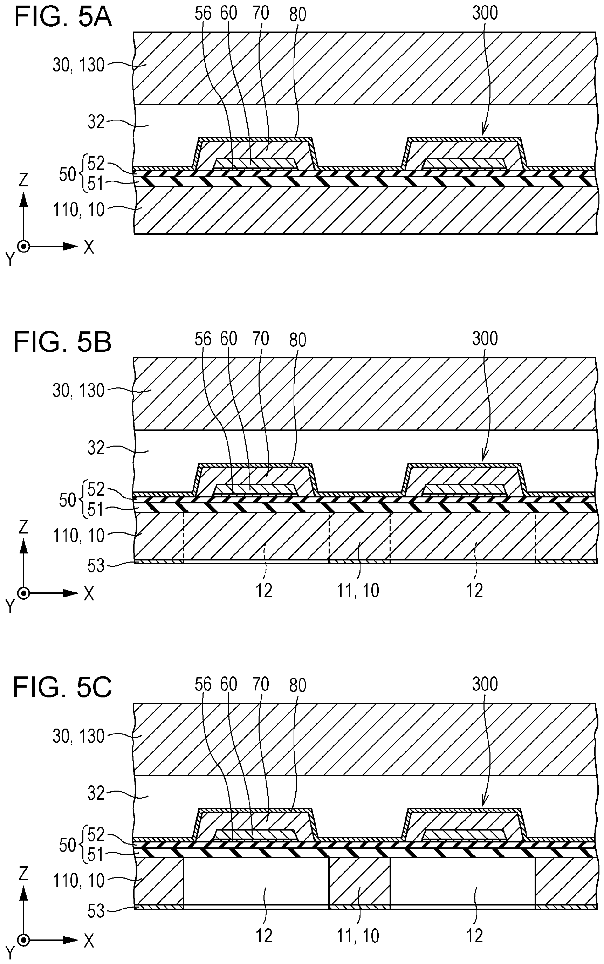

Next, as illustrated in Fig. 5A, a wafer for the protection substrate 130 is bonded to a surface of the piezoelectric element 300 side of the silicon substrate 110 through the adhesive 35 (refer to Fig. 3B). After that, a surface of the wafer for the protection substrate 130 is grinded to be thin. In addition, the manifold portion 32 or the through hole 33 (refer to Fig. 3B) is formed on the wafer for the protection substrate 130. Subsequently, as illustrated in Fig. 5B, on a surface of an opposite side of the piezoelectric element 300 of the silicon substrate 110, a mask film 53 is formed and the resultant is patterned to be a predetermined shape. Also, as illustrated in Fig. 5C, through the mask film 53, an anisotropic etching (wet etching) using an alkaline solution such as KOH is performed on the silicon substrate 110. Accordingly, aside from the pressure generating chamber 12 corresponding to each of the piezoelectric elements 300, the ink supplying path 13, the communication path 14, and the communication portion 15 (refer to Fig. 3B) are formed.

Next, an unnecessary part of an outer circumferential portion of the silicon substrate 110 and the wafer for the protection substrate 130 is cut and removed by dicing, or the like. Further, the nozzle plate 20 is bonded to a surface of an opposite side of the piezoelectric element 300 of the silicon substrate 110 (refer to Fig. 3B). In addition, the compliance substrate 40 is bonded to the wafer for the protection substrate 130 (refer to Fig. 3B). By the processes so far, a chip aggregate of the ink jet type recording head 1 is complete. When the aggregate is divided into each of chips, the ink jet type recording head 1 is obtained.

### Examples

Here, Examples of the invention will be described.

### Examples 1 to 4

A surface of 6-inch silicon substrate is thermally-oxidized, and the elastic film 51 which is a silicon dioxide film is formed on the substrate. Next, a zirconium film is sputtered on the elastic film 51, and the zirconium film is thermally-oxidized so that the zirconium oxide layer 52 is formed. Further, a titanium film is sputtered on the zirconium oxide layer, and the adhesion layer 56 having a thickness of 20 nm is prepared. Further, platinum is sputtered on the adhesion layer, and is patterned so as to be a predetermined shape, therefore, the first electrode 60 having a thickness of 200 nm is formed.

Subsequently, the piezoelectric layer 70 is formed in a sequence as follows. First, an n-octane solution of potassium acetate, an n-octane solution of sodium acetate, and an n-octane solution of pentaethoxyniobium are mixed, and thus the precursor solution is prepared. Four types of the precursor solutions are prepared so that a value of an x in Formula (4) described below is respectively 0.01 (Example 1), 0.5 (Example 2), 0.7 (Example 3), and 0.9 (Example 4).

(KₓNa₁₋ₓ)NbO₃ (x = 0.01, 0.5, 0.7, 0.9) ··· (4)

Subsequently, the prepared precursor solution is applied onto the substrate in which the first electrode 60 is formed by a spin coat method (coating process). Next, the substrate is placed on a hot plate, and dried at 180°C for several minutes (drying process). Subsequently, the substrate on the hot plate is pyrolyzed at 350°C for several minutes (pyrolyzing process). Also, it is fired at 700°C for five minutes (firing process) by a rapid thermal annealing (RTA) device. From the coating process to the firing process are respectively performed once on the piezoelectric film 74 of the first layer, and thus the film thickness thereof is 10 nm. Regarding the piezoelectric films 74 next for the second layer, a rotational speed of spin coating is lower than that of the first layer in the coating process, and the steps from the coating process to the pyrolyzing process are repeated five times to form five films and then the firing process is performed once, therefore, the film thickness of the five films is 100 nm. Eight layers of the five films of piezoelectric films 74 are formed in total, and the piezoelectric layer 70 having a thickness of 810 nm is obtained.

Iridium is sputtered on the produced piezoelectric layer 70, and thus the second electrode 80 having a thickness of 50 nm is produced. By the sequence described above, the piezoelectric elements in Examples 1 to 4 are produced.

### X-Ray Diffraction Pattern

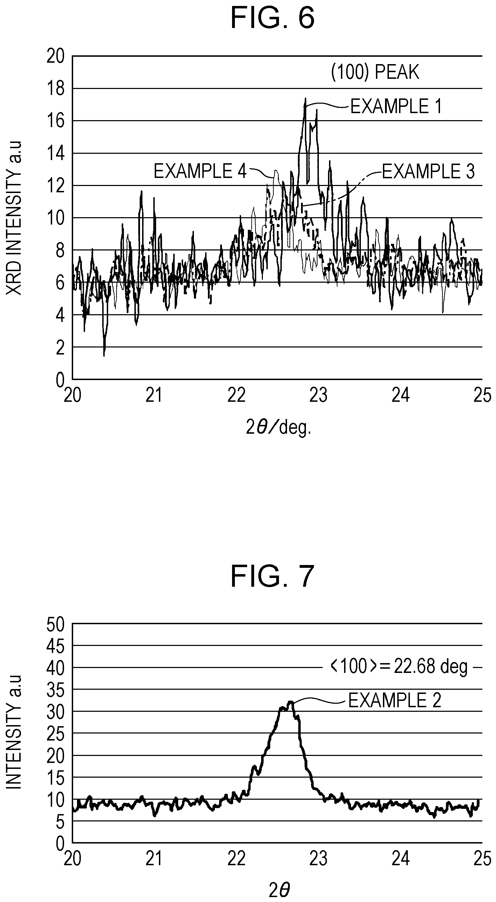

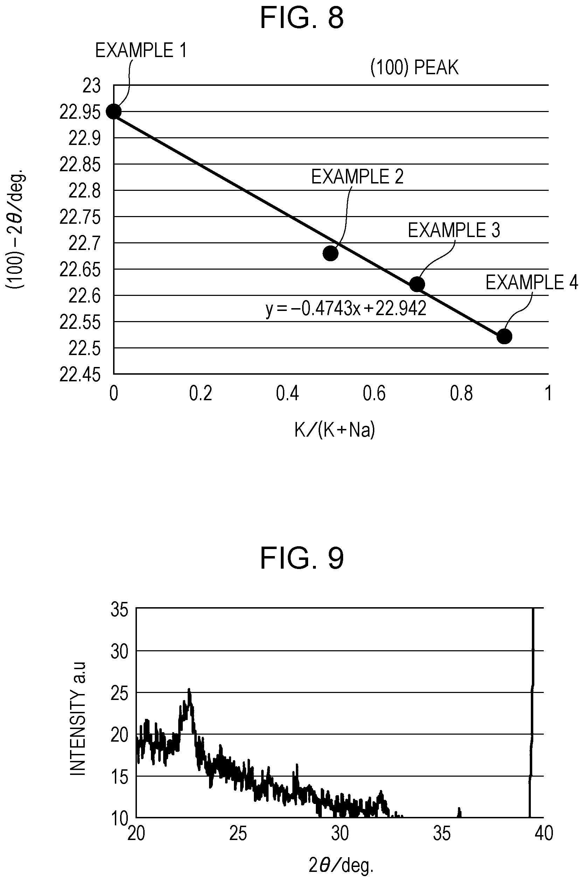

Regarding Example 1 (x = 0.01), Example 3 (x = 0.7), and Example 4 (x = 0.9), a measured result relating to a vicinity of the (100) plane peak of the X-ray diffraction pattern of the piezoelectric layer 70 is illustrated in Fig. 6. Regarding Example 2 (x = 0.5), a measured result relating to a vicinity of the (100) plane peak of the X-ray diffraction pattern of the piezoelectric layer 70 is illustrated in Fig. 7. In addition, a relationship of the diffraction peak position (2θ) of the (100) plane and the value of x is illustrated as a graph in Fig. 8.

According to the result, it is understood that the diffraction peak position (2θ) of the (100) plane in Examples 1 to 4 is in a range of 22.52 to 22.95°. In addition, with reference to Fig. 8, when a value of the diffraction peak position (2θ) of the (100) plane is set to y, it is understood that a relationship of y = -0.4743x + 22.942 is satisfied. When a range of 0 < x ≤0.90 is set according to the expression of the relationship, the diffraction peak position (2θ) of the (100) plane can be controlled to be in a range of 22.51° or more and 22.95° or less.

### Example 5

Other than a use of the precursor solution which is prepared so that a value of the x is 0.91 in Formula (4), the piezoelectric element is produced in the same sequence as Examples 1 to 4.

The diffraction peak position (2θ) of the (100) plane of the piezoelectric layer of the piezoelectric element is measured, and as a result, it is 22.51°. An upper value of the x (x = 0.91) guided from the relationship expression of Fig. 8 is verified to be appropriate. Comparative Example

The second electrode 80 and the piezoelectric layer 70 of Example 2 was peeled from the piezoelectric element and the internal stress thereof thus became relaxed, and it was set to Comparative example.

### X-Ray Diffraction Pattern

Regarding Comparative example, the measuring result of a vicinity of the (100) plane peak of the X-ray diffraction pattern is illustrated in Fig. 9. According to the result, the diffraction peak position (2θ) of the (100) plane is 22.68° (refer to Fig. 7) in Example 2, and is 22.50° in Comparative example.

### Examples 6 and 7

In the same manner as Example 2, except that the precursor solution, which is prepared so that the value of x in Formula (4) becomes 0.5, is used and a temperature of the firing process is changed from 700°C to 600°C, the piezoelectric element in Example 6 is produced in the same sequence as Example 2. In addition, except that the precursor solution, which is prepared so that the value of x in Formula (4) becomes 0.5, is used and a temperature of the firing process is changed from 700°C to 750°C, the piezoelectric element in Example 7 is produced in the same sequence as Example 2. Regarding Example 6 and 7, a vicinity of the (100) plane peak of the X-ray diffraction pattern of the piezoelectric layer 70 is measured, as a result, the diffraction peak position (2θ) of the (100) plane of the piezoelectric layer 70 in Example 6 which is fired at 600°C is 22.58°, and the diffraction peak position (2θ) of the (100) plane of the piezoelectric layer 70 in Example 7 which is fired at 750°C is 22.73°. The diffraction peak position (2θ) of the (100) plane of the piezoelectric layer 70 in Example 2 which is fired at 700°C is 22.68° as described above (refer to Fig. 7). In these Examples, it was found that the diffraction peak position (2θ) of the (100) plane of the piezoelectric layer 70 can be controlled by the firing temperature.

Next, when the second electrode 80 and the piezoelectric layer 70 are peeled from the piezoelectric elements of Example 6 and Example 7 and the X-ray diffraction pattern is measured, the diffraction peak position (2θ) of the (100) plane is commonly 22.50°. That is, 0.3% of distortion is generated in the film thickness direction in the piezoelectric layer 70 of Example 6 fired at 600°C, and 0.5% of distortion is generated in the film thickness direction in the piezoelectric layer 70 of Example 7 fired at 750°C.

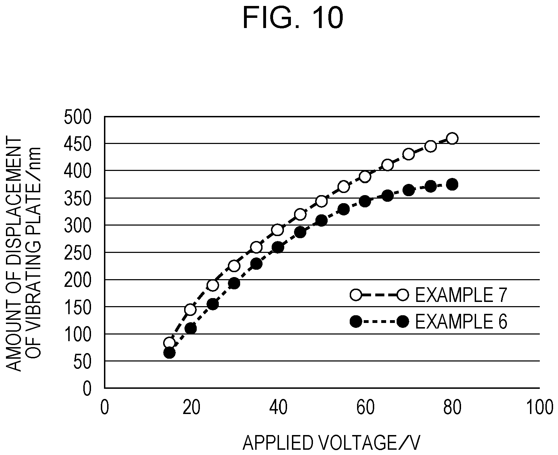

Further, the piezoelectric elements of Example 6 and Example 7 are mounted on a liquid ejecting head including the pressure generating chamber 12 having a 55 µm width (size of the X direction of Fig. 3A), and the displacement amount of the vibration plate 50 at the time of applied voltage is measured. The displacement amount is measured by a Doppler displacement meter. A result thereof is illustrated in Fig. 10. From Fig. 10, compared to a case of the liquid ejecting head in which the piezoelectric element of Example 6 is mounted, in a case of the liquid ejecting head in which the piezoelectric element of Example 7 is mounted, it is possible to recognize that a displacement of the vibration plate 50 increases rapidly immediately after a voltage is started to be applied, and saturation of the displacement amount at the time of increasing the applied voltage is small. This is because when distortion in a film is suitably generated, a rotation effect of polarization is added to a piezoelectric response with respect to the applied voltage, and an extension effect of polarization, a so called intrinsic piezoelectric effect, overlaps thereto. A state in which distortion in the film exists means a state in which a bias of distortion occurs. An effect increasing a margin of distortion, induced by an electric field with respect to boundary distortion broken by crystals of the piezoelectric layer, can be obtained by the distortion in the film. Therefore, an element including the distortion in the film has high mechanical and electrical reliability.

### Other Embodiment

Hitherto, one embodiment of the invention has been described. However, a basic configuration of the invention is not limited to the aspect described above.

In the embodiment described above, the silicon substrate 110 is exemplified as a material of the flow path forming substrate 10. However, the material of the flow path forming substrate 10 may be SOI, glass, or the like. Since any material has a possibility of reacting with an alkali metal derived from the piezoelectric layer, it is strongly preferable that the zirconium oxide layer which functions as a stopper of K or Na is provided.

In addition, in the embodiment, as an example of the piezoelectric element applying device, the ink jet type recording head is exemplified. However, the piezoelectric element according to the invention can be also applied to a liquid ejecting head which ejects liquid other than ink. As the liquid ejecting head which ejects liquid other than ink, for example, various recording heads used for an image recording apparatus such as a printer, a color ejecting head used for manufacturing a color filter such as a liquid crystal display, an electrode material ejecting head used for forming electrodes such as an organic EL display or field emission display (FED), a bio organic material ejecting head used for manufacturing a bio chip, and the like are exemplified.

In addition, the piezoelectric element according to the invention is not limited to the liquid ejecting head, and can be also used for the other piezoelectric element applying devices. As the piezoelectric element applying devices, for example, ultrasonic devices such as ultrasonic transmitters, ultra sonic motors, temperature- electric converters, pressure-electric converters, ferroelectric transistors, shield filters of harmful rays such as infrared rays, optical filters using a photonic crystal effect due to quantum dot formation, filters of optical filters using a light interference of thin film, and the like are exemplified. In addition, the invention can be also applied to the piezoelectric element used as a sensor and the piezoelectric element used as a ferroelectric memory. As a sensor used for the piezoelectric element, for example, infrared sensors, ultrasonic sensors, thermal sensors, pressure sensors, pyroelectric sensors, gyro sensors (angular rate sensors), and the like are exemplified.

In addition, the piezoelectric element according to the invention can be appropriately used as a ferroelectric element. As the ferroelectric element which can be appropriately used, a ferroelectric transistor (FeFET), a ferroelectric calculation circuit (FeLogic), a ferroelectric capacitor, and the like are exemplified. Further, the piezoelectric element according to the invention can be appropriately used for a pyroelectric element. As the pyroelectric element which can be appropriately used, a temperature detector, a biological detector, an infrared detector, a terahertz detector, a heat-electric converter, and the like are exemplified. These devices are also included in the piezoelectric elements, according to the invention application device.

Configuration elements illustrated in drawings, that is, a thickness, a width, a relative position relationship, and the like of the layer may be illustrated in an exaggerated manner in the description of the invention. In addition, the term "on" in this specification is not limited to the position relationship of the configuration elements indicated by "right above". For example, the description of "the zirconium oxide layer on the substrate" or "the first electrode on the zirconium oxide layer" also means other configurations include elements between the substrate and the zirconium oxide layer, and between the zirconium oxide layer and the first electrode. The foregoing description has been given by way of example only and it will be appreciated by a person skilled in the art that modifications can be made without departing from the scope of the present invention as defined by the claims.

## Claims

1. A piezoelectric element (300) comprising:
a first electrode (60) that is formed on a substrate (10);
a piezoelectric layer (70) that is formed on the first electrode and includes an ABO₃ type complex oxide of the perovskite structure expressed by Formula (1) below:
(K_{X}, Na_{1-X})NbO₃ ··· (1);
and
a second electrode (80) that is formed on the piezoelectric layer,
wherein the piezoelectric layer is made of a polycrystal which is preferentially oriented to a (100) plane, and has a thickness of 50 nm or more and 2000 nm or less,
wherein, in Formula (1), x is 0 or more and 0.91 or less, and
**characterized in that**, in the piezoelectric layer, a diffraction peak position (2θ) of an X-ray derived from the (100) plane of the piezoelectric layer is 22.51° or more and 22.95° or less, and 50% or more of the crystals of the piezoelectric layer are oriented to the (100) plane.

2. A piezoelectric element applying device comprising:
the piezoelectric element according to claim 1.

3. A manufacturing method of a piezoelectric element (300) which includes a first electrode (60) that is formed on a substrate, a piezoelectric layer (70) that is formed on the first electrode and includes an ABO₃ type complex oxide of the perovskite structure expressed by Formula (1) below:
(K_{X}, Na_{1-X})NbO₃ ··· (1),
x is 0 or more and 0.91 or less, and a second electrode (80) that is formed on the piezoelectric layer, the method comprising:
forming a piezoelectric layer, as the piezoelectric layer, which is made of a polycrystal preferentially oriented to a (100) plane, has a thickness of 50 nm or more and 2000 nm or less, and is **characterized by** having a diffraction peak position (2θ) of an X-ray derived from the (100) plane of 22.51° or more and 22.95° or less,
wherein 50% or more of the crystals of the piezoelectric layer formed in the forming step are oriented to the (100) plane.

4. The manufacturing method according to claim 3, further comprising
applying tensile stress by which a crystal lattice is contracted in a film thickness direction to the piezoelectric layer.

5. The manufacturing method according to claim 3 or claim 4,
wherein the step of forming the piezoelectric layer is a step of producing the piezoelectric layer by a wet method.

## Patentansprüche

1. Piezoelektrisches Element (300), aufweisend:
eine erste Elektrode (60), die auf einem Substrat (10) ausgebildet ist;
eine piezoelektrische Schicht (70), die auf der ersten Elektrode ausgebildet ist und ein ABO₃-Komplex-Oxid der Perowskitstruktur enthält, das durch folgende Formel (1) ausgedrückt ist:
(Kₓ, Na₁₋ₓ) NbO₃... (1);
und
eine zweite Elektrode (80), die auf der piezoelektrischen Schicht ausgebildet ist,
wobei die piezoelektrische Schicht aus einem Polykristall hergestellt ist, der bevorzugt auf eine (100) Ebene hin ausgerichtet ist und eine Dicke von größer gleich 50 nm und kleiner gleich 2000 nm aufweist,
wobei in der Formel (1) x größer gleich 0 und kleiner gleich 0,91 ist, und
**dadurch gekennzeichnet, dass** in der piezoelektrischen Schicht eine Beugungsspitzenposition (2θ) eines Röntgenstrahls, der von der (100) Ebene der piezoelektrischen Schicht abgeleitet ist, 22,51° oder mehr und 22,95° oder weniger beträgt, und
50 % oder mehr der Kristalle der piezoelektrischen Schicht auf die (100) Ebene hin ausgerichtet sind.

2. Aufbringungsvorrichtung für piezoelektrisches Element, aufweisend:
das piezoelektrische Element nach Anspruch 1.

3. Herstellungsverfahren eines piezoelektrischen Elements (300) mit: einer ersten Elektrode (60), die auf einem Substrat ausgebildet ist, einer piezoelektrischen Schicht (70), die auf der ersten Elektrode ausgebildet ist und einen ABO₃-Komplex-Oxid der Perowskitstruktur enthält, das durch folgende Formel (1) ausgedrückt ist:
(Kₓ, Na₁₋ₓ) NbO₃... (1),
mit x größer gleich 0 und kleiner gleich 0,91,
und einer zweiten Elektrode (80), die auf der piezoelektrischen Schicht ausgebildet ist, wobei das Verfahren Folgendes umfasst:
Bilden einer piezoelektrischen Schicht als die piezoelektrische Schicht, die aus einem Polykristall hergestellt ist, der bevorzugt auf eine (100) Ebene hin ausgerichtet ist, eine Dicke von 50 nm oder mehr und 2000 nm oder weniger aufweist und **dadurch gekennzeichnet ist, dass** sie eine Beugungsspitzenposition (2θ) eines Röntgenstrahls aufweist, der von der (100) Ebene von 22,51° oder mehr und 22,95° oder weniger abgeleitet ist,
wobei 50 % oder mehr der Kristalle der piezoelektrischen Schicht, die in dem Ausbildungsschritt ausgebildet werden, auf die (100) Ebene ausgerichtet werden.

4. Herstellungsverfahren nach Anspruch 3, das ferner umfasst:
Ausüben einer Zugspannung, durch die ein Kristallgitter in einer Filmdickerichtung zu der piezoelektrischen Schicht zusammengezogen wird.

5. Herstellungsverfahren nach Anspruch 3 oder Anspruch 4,
wobei der Schritt des Ausbildens der piezoelektrischen Schicht ein Schritt des Erzeugens der piezoelektrischen Schicht durch ein Nassverfahren ist.

## Revendications

1. Elément piézoélectrique (300) comprenant :
une première électrode (60) formée sur un substrat (10) ;
une couche piézoélectrique (70) formée sur la première électrode et qui comprend un oxyde complexe de type ABO₃ de structure pérovskite représenté par la formule (1) ci-dessous :
(Kₓ, Na₁₋ₓ) NbO₃... (1) ;
et
une deuxième électrode (80) formée sur la couche piézoélectrique,
dans lequel la couche piézoélectrique est formée par un polycristal de préférence orienté par rapport à un plan (100) et possède une épaisseur de 50 nm ou plus et 2000 nm ou moins,
dans lequel, dans la formule (1), x est de 0 ou plus et de 0,91 ou moins, et
**caractérisé en ce que**, dans la couche piézoélectrique, une position de pic de diffraction (2θ) d'un rayon X provenant du plan (100) de la couche piézoélectrique est de 22,51° ou plus et 22, 95° ou moins, et 50 % ou plus des cristaux de la couche piézoélectrique sont orientés par rapport au plan (100).

2. Dispositif d'application d'élément piézoélectrique comprenant :
l'élément piézoélectrique selon la revendication 1.

3. Procédé de fabrication d'un élément piézoélectrique (300) qui comprend une première électrode (60) formée sur un substrat, une couche piézoélectrique (70) formée sur la première électrode et qui comprend un oxyde complexe de type ABO₃ de structure pérovskite représenté par la formule (1) ci-dessous :
(Kₓ, Na₁₋ₓ) NbO₃... (1),
x étant de 0 ou plus et de 0,91 ou moins,
et une deuxième électrode (80) formée sur la couche piézoélectrique, le procédé comprenant :
la formation d'une couche piézoélectrique, en tant que la couche piézoélectrique, laquelle est formée par un polycristal de préférence orienté par rapport à un plan (100), a une épaisseur de 50 nm ou plus et 2000 nm ou moins, et est **caractérisée en ce qu'**elle a une position de pic de diffraction (2θ) d'un rayon X provenant du plan (100) de 22,51° ou plus et 22,95° ou moins,
dans lequel 50 % ou plus des cristaux de la couche piézoélectrique formée à l'étape de formation sont orientés par rapport au plan (100).

4. Procédé de fabrication selon la revendication 3, comprenant en outre
l'application d'une contrainte de traction grâce à laquelle un réseau cristallin est contracté dans un sens de l'épaisseur de pellicule par rapport à la couche piézoélectrique.

5. Procédé de fabrication selon la revendication 3 ou la revendication 4,
dans lequel l'étape de formation de la couche piézoélectrique est une étape de production de la couche piézoélectrique grâce à un procédé par voie humide.
